# EUROPEAN PATENT APPLICATION

(11) **EP 4 571 123 A1**
(43) Date of publication of application: **18.06.2025**
(21) Application number: 23216173.7
(22) Date of filing: 13.12.2023
(51) Int. Cl.: F16B 2/04, F16B 9/00, F16B 19/00, F16B 21/08

(54) **ANTI-VIBRATION MOUNTING BRACKET AND SYSTEM AND HOUSING WITH THE ANTI-VIBRATION MOUNTING BRACKET AND STANDALONE ELECTRONIC CONTROL UNIT WITH THE HOUSING**

(71) Applicant: ZF CV Systems Europe BV, 1170 Brüssel (BE)
(72) Inventor: BIALEK, Mateusz, 54-034 Wroclaw (PL); WOLANSKI, Michal, 54-129 Wroclaw (PL); ZABIEGLO, Wojciech, 52-405 Wroclaw (PL)
(74) Representative: Copi, Joachim

(57) **Abstract**

An anti-vibration mounting bracket 1, in particular for standalone electronic control units (ECUs), comprises a plastic portion 2 and a metallic portion 6 fixedly connected to the plastic portion. The metallic portion 6 comprises a first spring member 7 and a second spring member 8 located on opposite sides with respect to a longitudinal plane of the anti-vibration mounting bracket.

The plastic portion 2 of the anti-vibration mounting bracket 1 of the invention is at least partially overmoulded on the metallic portion 6.

## Description

The invention relates to an anti-vibration mounting bracket, in particular for a standalone electronic control unit (ECU), according to the preamble part of claim 1.

The invention also relates to a system comprising such an anti-vibration mounting bracket and a respective counterpart that is adapted to engage, in a locking manner, the anti-vibration mounting bracket. The present invention also relates to a housing comprising one or more systems comprising an anti-vibration mounting bracket and a respective counterpart, as well as a standalone electronic control unit (ECU) comprising such housing.

The anti-vibration mounting bracket of the above mentioned kind comprises:
a plastic portion comprising a support end and a snap-in end, said support end and snap-in end being located on opposite sides with respect to a transverse plane of the anti-vibration mounting bracket, the plastic portion comprising a bushing in correspondence of the support end.

Standalone ECUs are used to control one or more electrical systems or subsystems in a car or other motor vehicle. In the field of standalone electronic control units it is well known to enclose the printed circuit board (PCB) and other electronic components within a housing or covering in order to protect such components. The housing of the standalone ECU is designed for mounting on a respective motor vehicle, for instance a passenger car, a truck, or similar vehicle. Such housings are frequenly made of metal, for electromagnetic shielding purposes. The housing of a standalone ECU is normally mounted on a support structure of a vehicle to provide an ECU assembly. The ECU assembly with the ECU is provided through using a variety of means, for instance snap-in assemblies, specially adapted brackets, and the like.

It is known in the art to use plastic brackets adapted to be locked, in a snap-in fashion, into respective counterparts provided on the housing of the ECU.

Such plastic brackets are convenient and easy to use, however they present several problems. One of the problems of the plastic brackets relates to noise emissions generated by vibrations which are the result of fitting tolerances between brackets and counterparts.

Such fitting tolerances are necessary in order to be able to snap-in the plastic brackets into the respective counterparts. Furthermore, since the brackets are entirely made of plastic, they tend to lose tightness in the course of their lifetime, for instance because of the influence of temperature variations, stress relaxation, etc. which inevitably increases the issues relating to vibrations and noise. In the worst cases, excessive vibrations may also run the risk of damaging the electronic components of the ECU.

This is where the invention comes in, wherein it is an object of the present invention is therefore to provide an anti-vibration mounting bracket that solves the issues of prior art plastic brackets, in particular for mounting a standalone ECU.

One of the objects of the present invention is to provide an anti-vibration mounting bracket that reduces vibrations and noise emissions, thus improving users comfort. Another object of the present invention is to provide an anti-vibration mounting bracket that limits the issue of excessive stress relaxation and minimize the effect of temperature variations.

Another object of the present invention is to provide an anti-vibration mounting bracket that quickly adapts to existing ECUs and respective housings. Another object of the present invention is to provide an anti-vibration mounting bracket that makes it possible to firmly secure a standalone ECU to a vehicle, thus preserving the integrity and functionality, as well as enhancing the lifetime, of the electronic components. Another object of the present invention is to provide an anti-vibration mounting bracket that is compliant with industry standards.

Yet another object of the present invention is to provide an anti-vibration mounting bracket that is simple to assemble and that doesn't require the use of additional tools. Another object of the present invention is to provide a system comprising an anti-vibration mounting bracket and a respective counterpart as well as a housing comprising one or more of such systems and a standalone electronic control unit (ECU) comprising such housing.

These and other objects are achieved by an anti-vibration mounting bracket of claim 1.

The invention starts from said anti-vibration mounting bracket as mentioned in the introcuction. Therein the anti-vibration mounting bracket comprises a plastic portion. Such plastic portion comprises a support end and a snap-in end. The support end and snap-in end are located on opposite sides with respect to a transverse plane of the anti-vibration mounting bracket. The plastic portion comprises a bushing in correspondence of the support end.

According to the invention said anti-vibration mounting bracket of the invention also comprises a metallic portion fixedly connected to the plastic portion in correspondence of its snap-in end. The metallic portion comprises a first spring member and a second spring member, the first spring member and the second spring member being located on opposite sides with respect to a longitudinal plane of the anti-vibration mounting bracket. The plastic portion of the anti-vibration mounting bracket of the invention is at least partially overmoulded on the metallic portion.

The invention starts with an anti-vibration mounting bracket comprising a plastic portion of the mentioned kind, which forms a good starting point for an anti-vibration mounting. Still to improve the invention starts from the consideration that a metallic portion fixedly connected to the plastic portion in correspondence of its snap-in end, the metallic portion is well suited to improve fitting tolerances between brackets and counterparts, in particular to provide an anti-vibration mounting bracket that limits the issue of excessive stress relaxation and minimize the effect of temperature variations.

However, the invention, also recognized that said metallic portion should be adapted to interlock with both the the bracket and counterpart in a well selected way in order to be able to also reduce vibrations and noise emissions; to overcome this problem is not a selfunderstanding object as apparently to parts of a composite bracket at first sight could even worse the problem as compared to a one piece plastic anti-vibration mounting bracket. Still, however, the invention recognized that when the metallic portion comprises a first spring member and a second spring member, the first spring member and the second spring member being located on opposite sides with respect to a longitudinal plane of the anti-vibration mounting bracket, said tightness of fit between brackets and counterparts will improve even in view of fitting tolerances between brackets and counterparts. Further also a tight fit between the plastic portion and the metallic portion of the --thus generally plastic/metallic-composite-- anti-vibration mounting bracket of the invention is achieved in that the plastic portion is at least partially overmoulded on the metallic portion. The inventive approach in short terms thus stems from providing a plastic/metallic-composite anti-vibration mounting bracket providing an improved and lasting tight fit to a counterpart and still being as such integrally tight. Therefore the inventive concept of the composite anti-vibration mounting bracket allows to effectively ansd lastingly reduce noisy vibrations. In developments also retaining means can support this inventive approach.

The objects of the present invention are also achieved by a system comprising at least one anti-vibration mounting bracket as described above according to the invention and at least a respective counterpart adapted to engage in a locking manner with the metallic portion and/or with the snap-in end of the plastic portion of the anti-vibration mounting bracket.

Further advantageous developments of the invention are found in the dependent claims and indicate in detail advantageous possibilities to realize the concept described above within the scope of the object as well as with regard to further advantages.

According to one aspect, the first spring member and the second spring member are adapted to provide a constant pressure along a direction parallel to the transverse plane of the anti-vibration mounting bracket.

According to a preferred development of the invention, the metallic portion is made of steel.

According to one aspect of the invention, the plastic portion is made of a polymeric material, for instance ABS, (Acrylnitril-Butadien-Styrol), PE (Polyethylen), PP (Polypro-pylen), and the like.

According to a preferred development of the invention, the bushing is integral to the plastic portion of the anti-vibration mounting bracket and is therefore made of the same polymeric material.

According to an alternative embodiment of the invention, the bushing is not integral to the plastic portion of the anti-vibration mounting bracket and therefore can be made of the same polymeric material, a different polymeric material, a metallic material or a composite material.

According to a development, the first spring member of the anti-vibration mounting bracket of the invention comprises a first flat spring and the second spring member of the anti-vibration mounting bracket of the invention comprises a second flat spring. According to a preferred development, the metallic portion of the anti-vibration mounting bracket of the invention comprises a third spring member and a fourth spring member, the third spring member and the fourth spring member being located on the same side with respect to the transverse plane of the anti-vibration mounting bracket.

According to one aspect, both the third spring member and the fourth spring member are located on the side opposite to the support end of the plastic portion of the anti-vibration mounting bracket.

According to a preferred development, the third spring member and the fourth spring member are adapted to provide a constant pressure along a direction parallel to the longitudinal plane of the anti-vibration mounting bracket.

According to a preferred development, the third spring member comprises a first protruding pin and the fourth spring member comprises a second protruding pin, the first protruding pin and the second protruding pin being parallel with respect to each other and to the longitudinal plane of the anti-vibration mounting bracket.

According to one aspect, the first and second protruding pins are located at the end portions of respective flat or cantilever springs which are integrally formed with the metallic portion.

According to a preferred development, the metallic portion the anti-vibration mounting bracket of the invention comprises first retaining means to inhibit movement of the metallic portion with respect to the plastic portion along a direction parallel to the longitudinal plane of the anti-vibration mounting bracket.

According to one aspect, the first retaining means comprises at least one retaining element which is integrally formed with the metallic portion.

According to a preferred aspect, the first retaining means comprises at least two retaining elements which are integrally formed with the metallic portion.

According to a preferred development, the metallic portion of the anti-vibration mounting bracket of the invention comprises second retaining means to inhibit movement of the metallic portion with respect to the plastic portion along a direction parallel to the transverse plane of the anti-vibration mounting bracket.

According to one aspect, the second retaining means comprises at least one retaining element which is integrally formed with the metallic portion.

According to a preferred aspect, the second retaining means comprises at least two retaining elements which are integrally formed with the metallic portion.

According to a preferred embodiment, the plastic portion of the anti-vibration mounting bracket of the invention is overmoulded at least on the first retaining means and/or the second retaining means of the metallic portion.

According to a preferred embodiment, the plastic portion of the anti-vibration mounting bracket of the invention is not overmoulded on the first spring member and/or on the second spring member and/or the third spring member and/or the fourth spring member.

According to a preferred development, the metallic portion of the anti-vibration mounting bracket of the invention is manufactured through cutting, stamping, folding and/or bending a planar metal sheet.

According to a preferred development, the metallic portion of the anti-vibration mounting bracket of the invention comprises holes or cavities that allow the molten plastic to flow around, adhere to and encapsulate the metallic portion during the overmoulding process.

According to a preferred development, respective gaps are carved in the proximity of at least the first retaining means to allow molten plastic to flow around the metallic portion during the overmoulding process.

According to one aspect of the invention, the counterpart is made of a polymeric material.

According to a preferred aspect, the counterpart is made of the same polymeric material of the plastic portion of the anti-vibration mounting bracket.

According to an alternative aspect, the counterpart is made of metallic material.

According to a preferred development, the counterpart comprises first and second recesses adapted to respectively engage with the first spring member and the second spring member.

According to a preferred aspect, the counterpart comprises lateral walls adapted to engage with the first flat spring of the first spring member and with the second flat spring of the second spring member.

According to a preferred aspect, the counterpart comprises a back wall adapted to engage with the first and second protruding pins of the third and fourth spring members.

The objects of the present invention are also achieved by a housing comprising at least a system comprising an anti-vibration mounting bracket and a respective counterpart adapted to engage in a locking manner with the metallic portion and/or with the snap-in end of the plastic portion of the anti-vibration mounting bracket.

According to a preferred development, the housing of the present invention is made of plastic.

According to an alternative embodiment, the housing of the present invention is made of metal.

According to a preferred development, the housing of the present invention comprises a plurality of systems comprising an anti-vibration mounting bracket as described above and a respective counterpart adapted to engage in a locking manner with the metallic portion and/or with the snap-in end of the plastic portion of the anti-vibration mounting bracket.

The objects of the present inventions are also achieved by a standalone electronic control unit comprising the housing as described above.

For a more complete understanding of the invention, the invention will now be described in detail with reference to the accompanying drawings. The detailed description will illustrate and describe what is considered as a preferred embodiment of the invention. It should of course be understood that various modifications and changes in form or detail could readily be made without departing from the spirit of the invention. It is therefore intended that the invention may not be limited to the exact form and detail shown and described herein, nor to anything less than the whole of the invention disclosed herein and as claimed hereinafter. Further, the features described in the description, the drawings and the claims disclosing the invention may be essential for the invention considered alone or in combination. In particular, any reference signs in the claims shall not be construed as limiting the scope of the invention.

The general concept of the invention is not limited to the exact form or detail of the preferred embodiments shown and described below or to a subject matter, which would be limited in comparison to the subject matter as claimed in the claims.

For specified design ranges, values within specified limits of the ranges are also disclosed as limit values and thus are arbitrarily applicable and claimable.

The wording "comprising" does not exclude other elements or steps. The word "a" or "an" does not exclude the plurality. The wording "a number of" items comprises also the number 1 , i.e. a single item, and further numbers like 2, 3, 4 and so forth.

In the accompanying drawings it is shown in:
- FIG. 1A: a comparing example of a mounting bracket and a corresponding counter part;
- FIG. 1B: a comparing example of a mounting bracket engaged, in a locking manner, with the corresponding counterpart;
- FIG. 2A: the anti-vibration mounting bracket of the invention and a corresponding counterpart according to a preferred embodiment;
- FIG. 2B: the anti-vibration mounting bracket of the invention engaged, in a locking manner, with the corresponding counterpart according to the preferred embodiment;
- FIG. 3A: an axonometric view of the anti-vibration mounting bracket of the invent tion according to the preferred embodiment;
- FIG. 3B: an axonometric view of the anti-vibration mounting bracket of the invention, with the plastic portion being rendered with a partially transparent shading, according to the preferred embodiment;
- FIG. 3C: a longitudinal section view of the anti-vibration mounting bracket of the invention according to the preferred embodiment;
- FIG. 3D: a top view of the anti-vibration mounting bracket of the invention according to the preferred embodiment;
- FIG. 4: an unfolded metallic portion of the anti-vibration mounting bracket of the invention according to the preferred embodiment;
- FIG. 5: the metallic portion of the anti-vibration mounting bracket of the invention after folding and before plastic overmoulding according to the preferred embodiment;
- FIG. 6A: the anti-vibration mounting bracket of the invention engaged, in a locking manner, with a corresponding counterpart, such counterpart being rendered as partially sectioned, i.e. with its top wall removed, according to the preferred embodiment;
- FIG. 6B: a top view of FIG. 6A;
- FIG. 7: shows a standalone ECU having a housing including four anti-vibration mounting brackets of the invention engaged, in a locking manner, with four corresponding counterparts according to a preferred embodiment to provide an ECU assembly in a vehicle;
- FIG. 8: shows a standalone ECU having a housing including four counterparts and four anti-vibration mounting brackets of the invention, ready to be engaged in the respective counterparts according to a preferred embodiment to provide an ECU assembly in a vehicle.

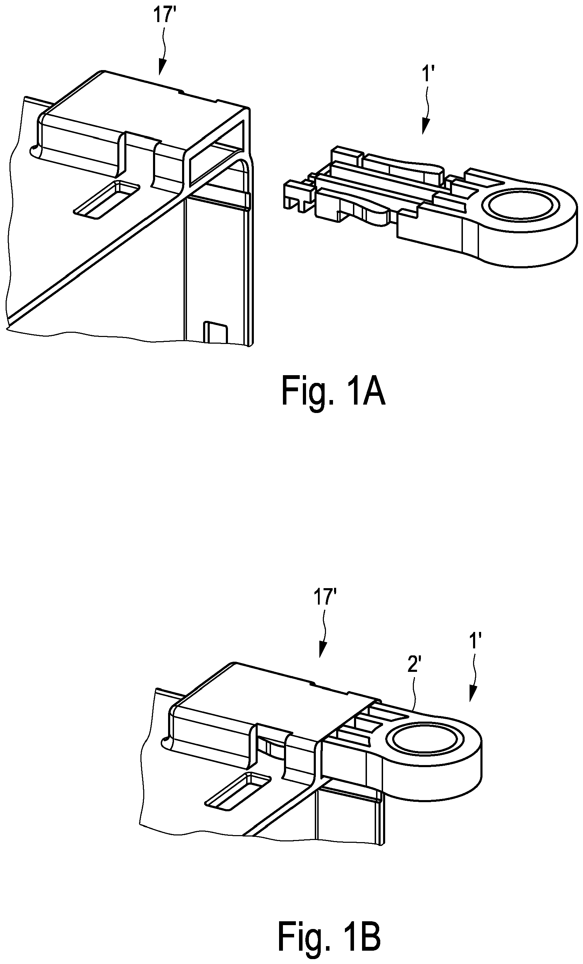

Mounting brackets 1' as shown in FIG. 1A were entirely made of plastic so that, once inserted into a respective counterpart 17', pressure had to be exerted by the contact of plastic portions 2' of the mounting brackets 1' as is shown in FIG. 1B.

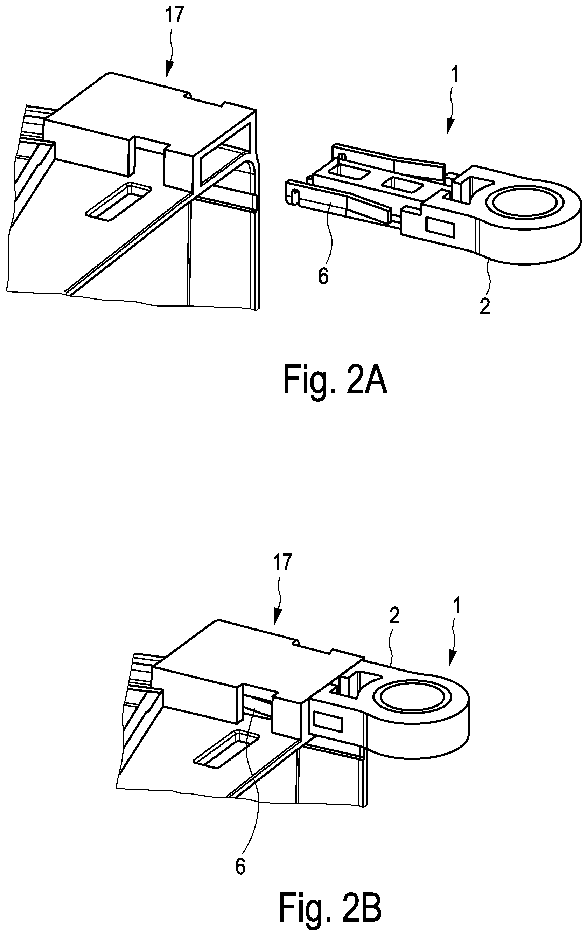

With reference to FIG. 2A, by contrast the composite anti-vibration mounting bracket 1 of the invention comprises a plastic portion 2 and a metallic portion 6. When the anti-vibration mounting bracket 1 of the invention is inserted into a respective counterpart 17, a firm connection is ensured by pressure exerted by the metallic portion 6 on the internal walls of the counterpart 17 as can be seen at best from FIG. 2B.

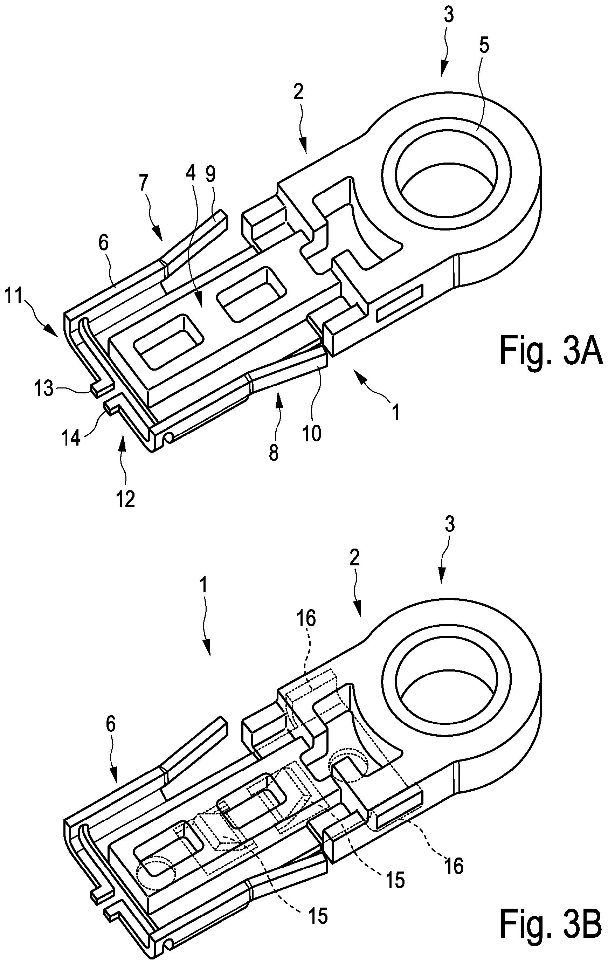

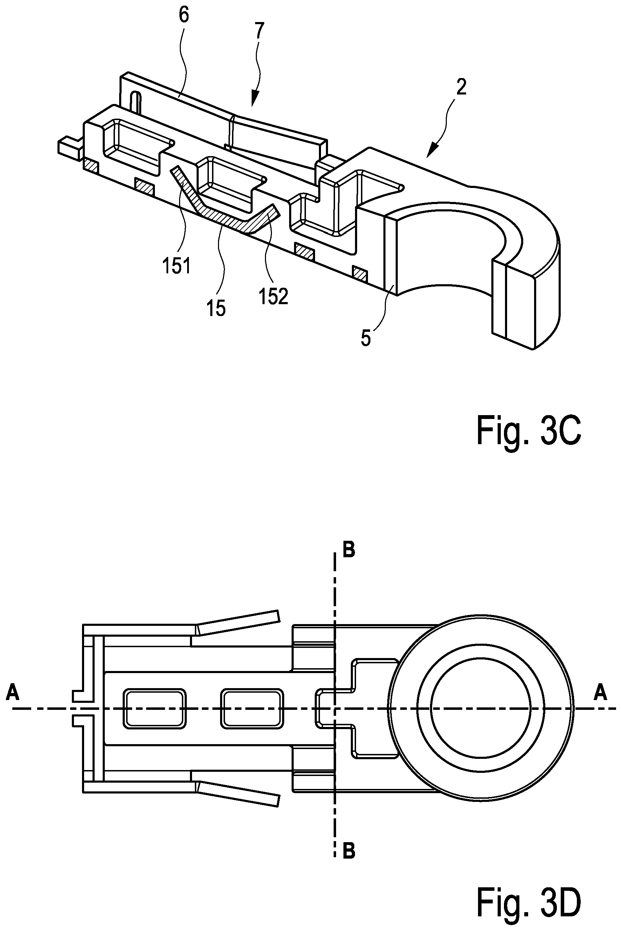

With reference to FIG. 3A to FIG. 3D, the plastic portion 2 comprises a support end 3 and a snap-in end 4 located on opposite sides with respect to a transverse plane BB of the anti-vibration mounting bracket 1. The support end 3 of the plastic portion 2 comprises a bushing 5 that is designed to be fitted to a pin or similar fixing means of a supporting structure, generally located in the interior of a motor vehicle. The bushing 5 may be made of either polymeric material, metallic material, composite material, or the like. The bushing 5 may also be an integral part of the plastic portion 2. The snap-in end 4 of the plastic portion 2 is generally adapted to be fitted into a respective counterpart 17.

The metallic portion 6 is fixedly connected to the plastic portion 2 approximately in correspondence of the snap-in end 4 of the plastic portion 2 and comprises a first spring member 7 and a second spring member 8 which are located on opposite sides with respect to a longitudinal plane AA of the anti-vibration mounting bracket 1. The first spring member 7 and the second spring member 8 each comprise a respective first flat spring 9 and second flat spring 10 that protrude outward with respect of the anti-vibration mounting bracket 1, in a direction substiantally parallel to the transverse plane BB. The metallic portion 6 also comprises a third spring member 11 and a fourth spring member 12, said third spring member 11 and fourth spring member 12 being located on the same side with respect to the transverse plane BB of the anti-vibration mounting bracket and, specifically, they are located opposite to the support end 3 of the plastic portion 2.

The third spring member 11 and the fourth spring member 12 are i.e. cantilever springs and each comprise respective first protruding pin 13 and second protruding pin 14, the first protruding pin 13 and the second protruding pin 14 being parallel with respect to each other and to the longitudinal plane AA of the anti-vibration mounting bracket 1. The metallic portion 6 of the anti-vibration mounting bracket 1 comprises first retaining means 15 (shown in shaded view, dashed reference line) to inhibit movement of the metallic portion 6 with respect to the plastic portion 2, along a direction parallel to the longitudinal plane AA of the anti-vibration mounting bracket 1.Such first retaining means 15 may be shaped in many different ways, i.e. as hooks, cantilevers, brackets, and the like and generally at least partially protrude outwards with respect of the plane of the metallic portion 6.

The metallic portion 6 also comprises second retaining means 16 (shown in shaded view, dashed reference line) to inhibit movement of the metallic portion 6 with respect to the plastic portion 2, along a direction parallel to the transverse plane BB of the anti-vibration mounting bracket 1.

Such second retaining means 16 may also be shaped in many different ways. Preferably, they are shaped as cantilevers protruding ouwards with respect of the plane of the metallic portion 6.

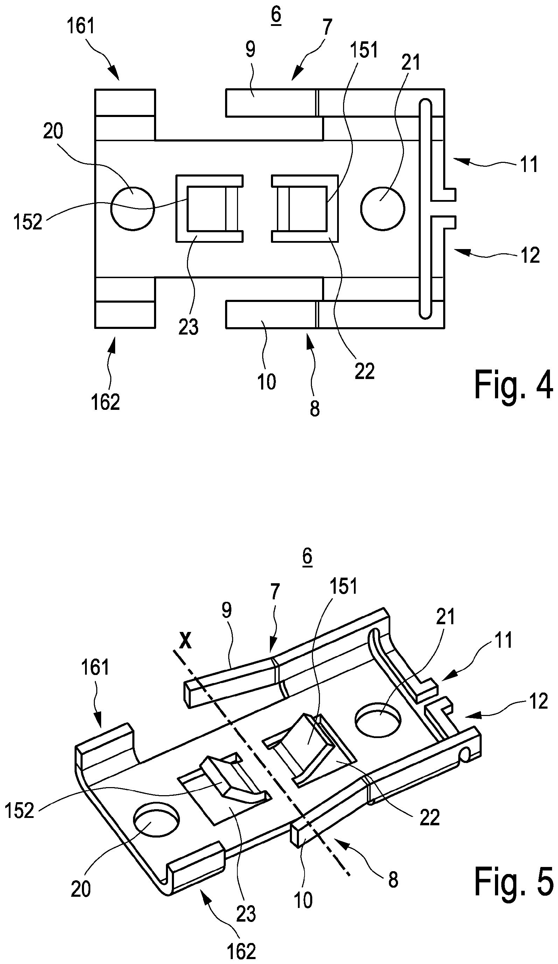

With reference to FIG. 4 and FIG. 5, the metallic portion 6 is mostly planar in shape and manufactured from a planar metal sheet that is cut into an intermediate shape before being formed by either bending or folding. The first retaining means 15 of the metallic portion 6 comprises a first protrusion 151 and a second protrusion 152 that are shaped as a loosely resembling hook that is bending away from the plane of the original metal sheet, around an axis x that is parallel to the transversal plane BB of the anti-vibration mounting bracket 1.

Around the first protrusion 151 and the second protrusion 152 respective gaps 22, 23 are carved out of the metal sheet to facilitate the bending of the protrusions as well as the flow of the molten polymer during the overmoulding step.

Also in order to facilitate the flow of the molten polymer, holes 20 and 21 are provided on the metal sheet. The second retaining means 16 comprises a first cantilever 161 and a second cantilever 162 disposed on opposite sides with respect to a direction parallel to the longitudinal plane AA of the anti-vibration mounting bracket 1.

After the metal sheet has been cut and folded and formed into the metallic portion 6, such metallic portion 6 is overmoulded by molten polymer so that to form the plastic portion 2, for instance by well-known injection molding techniques.

The plastic portion 2 is overmoulded at least on the first retaining means 15 and/or on the second retaining means 16 of the metallic portion 6, in order to ensure a firm connection between the plastic and the metallic portions. Additional parts of the metallic portion 6 may also be overmoulded by the plastic portion 2; however, the first, second, third and fourth spring members 7, 8, 11, 12 are preferably not overmoulded. As a general rule, no metal spring member that is designed to come into contact with the walls of the counterpart should be overmoulded. This does not rule away the possibility that parts of the plastic portion 2 may nevertheless come into contact with the walls of the counterpart.

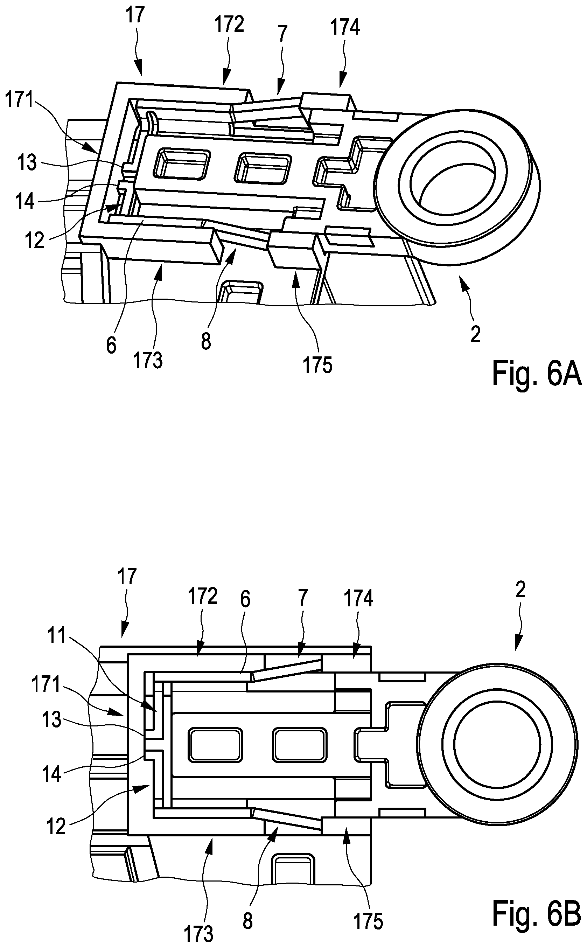

With reference to FIG. 6A and FIG. 6B, the anti-vibration mounting bracket 1 firmly engages the counterpart 17 in several ways.

The first spring member 7 exerts a constant pressure against the first lateral wall 172 of the counterpart, and similarly does the second spring member 8 againts second lateral wall 173, thus blocking movement along a direction parallel to the transversal plane BB of the anti-vibration mounting bracket 1. At the same time, the first and second protruding pins 13, 14, supported by third and fourth spring members 11, 12 extert constant pressure against back wall 171 of the counterpart 17, thus preventing movement along a direction parallel to the longitudinal plane AA of the anti-vibration mounting bracket 1. In addition, the first and second spring members 7, 8 protrude out of recesses in the lateral walls of the counterpart and abut against respective front faces of third lateral wall 174 and of fourth lateral wall 175, thus contributing to blocking any movement along a direction parallel to the longitudinal plane AA, at the same time improving the stability of the blocking along a direction parallel to the transversal plane BB.

The anti-vibration mounting bracket 1 of the invention, when coupled with a respective counterpart 17, therefore minimizes vibrations and noise thanks to the constant pressure exerted by the metallic portion 6 against the walls of the counterpart 17, which ensures a firm and stable connection over a long period of time.

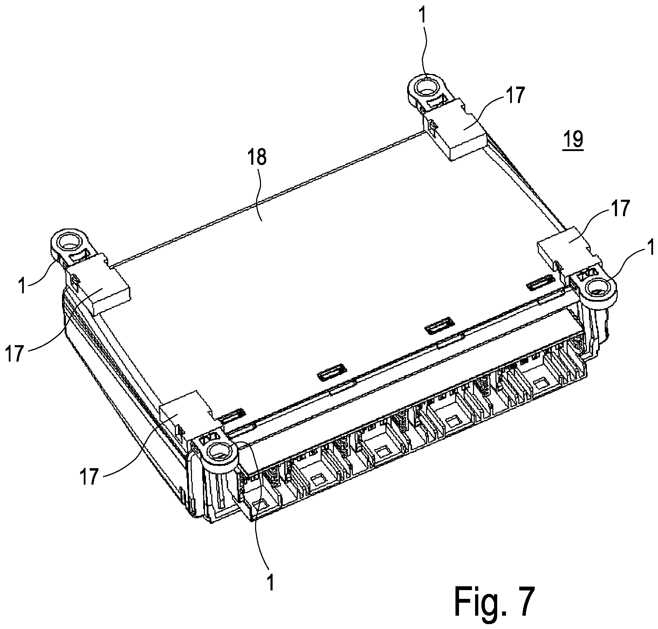

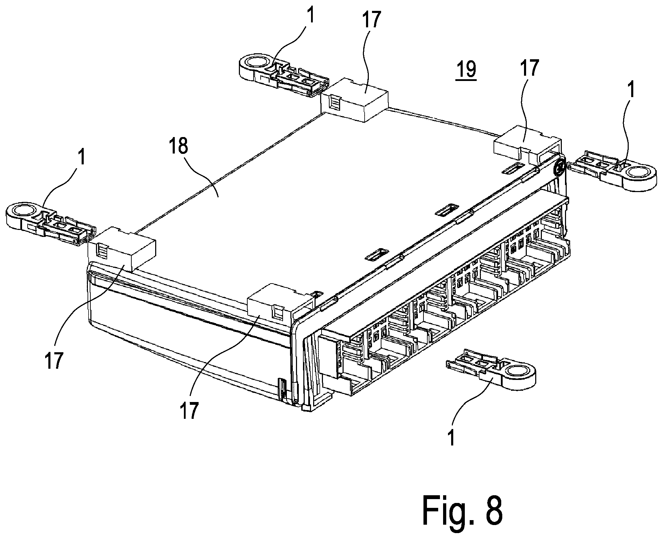

With reference to FIG. 7 and FIG. 8, a standalone ECU 19 is provided with a housing 18 comprising four counterparts 17 to provide an ECU assembly in a vehicle (not shown). Each of the four counterparts 17 is adapted to receive a corresponding anti-vibration mounting bracket 1 by snap-in insertion. The standalone ECU can thus be mounted on an interior wall of a vehicle (not shown), via the bushings 5 provided in the plastic portion 2 of each anti-vibration mounting bracket 1 to provide the ECU assembly of ECU and counterparts in the vehicle.

The housing 18 of the ECU 19 may be made of metal or plastic and its dimensions can be standardized, so that positioning of the counterparts 17 may be set in advance on the housing; thus establishing the ECU assembly. The ECU assembly is adapted to greatly facilitate attachment of the ECU 19 on the support structure of the vehicle.

The metallic portion 6 of the anti-vibration mounting bracket 1 can help shielding the ECU from electromagnetic interferences, especially so when the housing 18 is made of plastic. A similar enhancement of the electromagnetic shielding effect may be provided by the bushing 5, in case when the bushing is made of metal.

In summary herein a composite anti-vibration mounting bracket 1, in particular for a standalone electronic control unit (ECU) is described. The anti-vibration mounting bracket 1 of composite kind thus comprises a plastic portion 2 and a metallic portion 6 fixedly connected to the plastic portion. The metallic portion 6 comprises a first spring member 7 and a second spring member 8 located on opposite sides with respect to a longitudinal plane of the anti-vibration mounting bracket. The plastic portion 2 of the anti-vibration mounting bracket 1 of the invention is at least partially overmoulded on the metallic portion 6.

In the claims, the word "comprising" does not exclude other elements or steps, and the indefinite article "a" or "an" does not exclude a plurality.

A single unit or device may fulfill the functions of several items recited in the claims. The mere fact that certain measures are recited in mutually different dependent claims does not indicate that a combination of these measures cannot be used to advantage.

Any reference signs in the claims should not be construed as limiting the scope.

### List of reference signs (part of the description)

- 1: anti-vibration mounting bracket
- 2: plastic portion
- 3: support end
- 4: snap-in end
- 5: bushing
- 6: metallic portion
- AA: direction (top view) of a longitudinal plane of the mounting bracket
- BB: direction (top view) of a transversal plane of the mounting bracket
- x: axis parallel to transversal plane BB
- 7: first spring member
- 8: second spring member
- 9: first flat spring
- 10: second flat spring
- 11: third spring member
- 12: fourth spring member
- 13: first protruding pin
- 14: second protruding pin
- 15: first retaining means
- 151: first protrusion
- 152: second protrusion
- 16: second retaining means
- 161: first cantilever
- 162: second cantilever
- 17: counterpart for ECU to provide an ECU assembly in a vehicle
- 171: back wall
- 172: first lateral wall
- 173: second lateral wall
- 174: third lateral wall
- 175: fourth lateral wall
- 18: housing of ECU
- 19: ECU
- 20, 21: hole
- 22, 23: gap

## Claims

1. An anti-vibration mounting bracket (1), in particular for a standalone electronic control unit, the anti-vibration mounting bracket (1) comprising:
a plastic portion (2) comprising a support end (3) and a snap-in end (4), said support end (3) and snap-in end (4) being located on opposite sides with respect to a transverse plane (BB) of the anti-vibration mounting bracket (1), the plastic portion (2) comprising a bushing (5) in correspondence of the support end (3);
**characterized by**
a metallic portion (6) fixedly connected to the plastic portion (2) in correspondence of the snap-in end (4) of said plastic portion (2), the metallic portion (6) comprising a first spring member (7) and a second spring member (8), said first spring member (7) and second spring member (8) being located on opposite sides with respect to a longitudinal plane (AA) of the anti-vibration mounting bracket (1), wherein
the plastic portion (2) is at least partially overmoulded on the metallic portion (6).

2. The anti-vibration mounting bracket (1) according to claim 1, wherein the first spring member (7) comprises a first flat spring (9) and the second spring member (8) comprises a second flat spring (10).

3. The anti-vibration mounting bracket (1) according to any of claims 1 or 2, wherein the metallic portion (6) comprises a third spring member (11) and a fourth spring member (12), said third spring member (11) and fourth spring member (12) being located on a same side with respect to the transverse plane (BB) of the anti-vibration mounting bracket (1).

4. The anti-vibration mounting bracket (1) according to claim 3, wherein the third spring member (11) comprises a first protruding pin (13) and the fourth spring member (12) comprises a second protruding pin (14), the first protruding pin (13) and the second protruding pin (14) being parallel with respect to each other and to the longitudinal plane (AA) of the anti-vibration mounting bracket (1).

5. The anti-vibration mounting bracket (1) according to any of the preceding claims, wherein the metallic portion (6) comprises first retaining means (15) to inhibit movement of the metallic portion (6) with respect to the plastic portion (6) along a direction parallel to the longitudinal plane (AA) of the anti-vibration mounting bracket.

6. The anti-vibration mounting bracket (1) according to any of the preceding claims, wherein the metallic portion (6) comprises second retaining means (16) to inhibit movement of the metallic portion (6) with respect to the plastic portion (2) along a direction parallel to the transverse plane (BB) of the anti-vibration mounting bracket (1).

7. The anti-vibration mounting bracket (1) according to any of claims 5 or 6, wherein the plastic portion (2) is overmoulded at least on the first retaining means (15) and/or on the second retaining means (16) of the metallic portion (6).

8. A system comprising:
at least one anti-vibration mounting bracket (1) according to any of claims 1 to 7 and
at least a counterpart (17), in particular to provide an ECU assembly in a vehicle, adapted to engage in a locking manner with the metallic portion (6) and/or with the snap-in end (4) of the plastic portion (2) of the anti-vibration mounting bracket (1).

9. A housing (18) comprising the system according to claim 8.

10. A standalone electronic control unit (19) comprising the housing (18) according to claim 9.
